# EUROPEAN PATENT APPLICATION

(11) **EP 2 214 218 A2**
(43) Date of publication of application: **04.08.2010**
(21) Application number: 09009789.0
(22) Date of filing: 29.07.2009
(51) Int. Cl.: H01L 33/50

(54) **Light emitting diode unit, display apparatus having the same and manufacturing method of the same**

(30) Priority: 02.02.2009 KR 20090007946
(71) Applicant: Samsung Electronics Co., Ltd., Yeongtong-gu Suwon-city, Gyeonggi-do 442-742 (KR)
(72) Inventor: Byun, Jinseob, Seoul (KR)
(74) Representative: Dr. Weitzel & Partner

(57) **Abstract**

Disclosed are a light emitting diode unit, a display apparatus having the same, and a method of manufacturing the same. The light emitting diode unit includes at least one light emitting diode (220), a quantum dot layer (240), and a buffer layer (230). The light emitting diode emits first light. The quantum dot layer is provided on the light emitting diode and includes a plurality of quantum dots (242,244) that absorb the first light to emit second light having a wavelength different from a wavelength of the first light. The buffer layer is interposed between the light emitting diode and the quantum dot layer and separates the light emitting diode from the quantum dot layer. The buffer layer includes a scattering agent (232) which is dispersed in resin to diffuse the light emitted from the light emitting diode.

## Description

### CROSS-REFERENCE TO RELATED APPLICATION

This application claims priority to Korean Patent Application No. 10-2009-0007946 filed on February 02, 2009, the contents of which are herein incorporated by reference in their entirety.

### BACKGROUND OF THE INVENTION

### 1. Technical Field

The present invention relates to a light emitting diode unit, and more particularly, the present invention relates to a light emitting diode unit, a display apparatus having the light emitting diode unit, and a method of manufacturing the light emitting diode unit.

### 2. Discussion of the Related Art

A light emitting diode (LED) is a form of solid-state light source having a structure of a p-n junction. In the light emitting diode, energy of electrons is converted into light that is emitted. Electrons and holes, which are injected into the semiconductor from electrodes, are recombined in a region adjacent to the p-n junction when the energy exceeds a band gap (EG) of the p-n junction. During the recombination of the electrons and the holes, the energy corresponding to the band gap is emitted from the light emitting diode as light.

While an LED may be theoretically designed to emit light of any desired wavelength, many commercial applications of light emitting diode units utilize light emitting diodes that emit light of one of the three primary colors, i.e., red, green, and blue. While light emitted from any one LED is monochromatic, there are several methods for producing an LED unit that provides white light. According to one such approach, the light from red, green and blue LEDs may be combined to generate white light. According to another approach, monochromatic LEDs may be used to excite a phosphor material that emits white light as it relaxes. In this way, monochromatic LED light may be converted into white light using the phosphor material in a manner similar to how white light is produced in fluorescent light bulbs.

According to another approach, where a light emitting diode unit employs a light emitting diode emitting a blue light, a red fluorescent material and a green fluorescent material may be applied to the light emitting diode unit to absorb portions of the blue light so as to emit red light and green light, resulting in making the white light by mixing the blue light, the red light and the green light.

However, blue light has superior color reproducibility since its full-width half maximum (FWHM) is relatively narrow. The full-width half-maximum of light emitted from red fluorescent material and the green fluorescent material is relatively wide, so that the color reproducibility of the light emitting diode unit is deteriorated.

### SUMMARY OF THE INVENTION

Exemplary embodiments of the present invention provide for an LED unit with enhanced color reproduction and an extended lifespan.

Exemplary embodiments of the present invention provide a display apparatus having enhanced color reproduction and an extended lifespan by using the LED unit as a light source.

Exemplary embodiments of the present invention also provide a method of manufacturing the LED unit.

In one aspect of the present invention, a light emitting diode unit includes at least one light emitting diode, a quantum dot layer, and a buffer layer. The light emitting diode emits a first light. The quantum dot layer is provided on the light emitting diode and includes a plurality of quantum dots. The quantum dots absorb the first light and then emit a second light having a wavelength different from a wavelength of the first light. The buffer layer is interposed between the light emitting diode and the quantum dot layer.

Each quantum dot has a diameter of about 4nm to about 10nm and includes a core, a shell and a ligand. The shell surrounds the core and includes material having a bandgap larger than a bandgap of the quantum dot. The ligand is attached to the shell.

The buffer layer includes resin and scattering agent. The scattering agent is dispersed within the resin to diffuse the first light emitted from the light emitting diode.

The scattering agent includes a plurality of particles. Each particle may have a diameter larger than the diameter of the quantum dot. The particle may have a diameter of about 50nm to about 10µm and may be larger than a wavelength of blue light.

The resin may include polymer resin such as silicon resin, epoxy resin and/or acryl resin.

The scattering agent is contained in the resin at a ratio of about 1 % by weight to about 15 % by weight based on the weight of the resin.

The buffer layer may include a plurality of buffer sub-layers. A different concentration of the scattering agent may be used in each buffer sub-layer. The buffer layer has a dual layer structure in which a first buffer sub-layer is formed on the light emitting diode, and a second buffer sub-layer is formed on the first buffer sub-layer. The scattering agent in the first buffer sub-layer may have a concentration lower than the concentration of the scattering agent in the second buffer sub-layer.

The scattering agent may include bead glass, titanium oxide, aluminum oxide and/or silica glass.

The light emitting diode unit can be used as a light source of a display apparatus. The display apparatus according to an exemplary embodiment of the present invention includes a display panel, for example, a liquid crystal display (LCD) panel, and the light emitting diode unit. The display panel displays images. The light emitting diode unit supplies light to the display panel.

Exemplary embodiments of the present invention include a method of manufacturing the light emitting diode unit. According to the method, a light emitting diode is mounted on a housing. Next, a buffer layer is formed on the light emitting diode using buffer resin. Then, a quantum dot layer is formed on the buffer layer.

The buffer layer is formed by mixing a solid-phase scattering agent with a first buffer resin to form a first mixture, coating the first mixture on the light emitting diode, and curing the first mixture.

The quantum dot layer is formed by preparing quantum dots mixed with solvent, forming a second mixture by mixing the quantum dots with second buffer resin, coating the second mixture on the buffer layer, and curing the second mixture.

The first mixture is cured through thermosetting and/or photo-curing. The second mixture is cured through thermosetting.

As described above, the present invention can provide an LED unit having a relatively high degree of color reproduction. The LED unit is provided with a buffer layer that diffuses light emitted from the LED and accordingly, deterioration of the quantum dots can be reduced or prevented. Thus, the color reproduction of LED unit can be maintained and the lifespan of the LED unit can be extended.

Further, in using the LED unit within a display apparatus, the display apparatus may have a relatively high degree of color reproduction and a long lifespan.

Further, the LED unit can be effectively manufactured through a simple process.

### BRIEF DESCRIPTION OF THE DRAWINGS

The above and other features and aspects of the exemplary embodiments of the present invention will become readily apparent by reference to the following detailed description when considered in conjunction with the accompanying drawings wherein:
FIG. 1 is a sectional view illustrating an LED unit according to an exemplary embodiment of the present invention;
FIG. 2A is a spectral distribution graphs of a conventional LED unit using fluorescent material according to an exemplary embodiment of the present invention;
FIG. 2B is a spectral distribution graph of an LED unit according to an exemplary embodiment of the present invention;
FIG. 3 is a sectional view illustrating an LED unit according to an exemplary embodiment of the present invention;
FIG. 4A is a view showing spatial light distribution of an LED unit when no scattering agent is used;
FIG. 4B is a view showing a spatial light distribution of an LED unit when a scattering agent is used;
FIG. 5 is a graph showing spatial light distribution shown in FIGS. 4A and 4B;
FIG. 6 is a graph showing light quantity characteristics as a function of aging time when no scattering agent is used and when a scattering agent is used;
FIG. 7 is a graph showing x-coordinate colorimetric characteristics as a function of aging time when no scattering agent is used and when scattering agent is used;
FIG. 8 is a graph showing y-coordinate colorimetric characteristics as a function of aging time when no scattering agent is used and when scattering agent is used;
FIG. 9 is a sectional view illustrating an LED unit according to an exemplary embodiment of the present invention;
FIG. 10 is a sectional view illustrating an LED unit according to an exemplary embodiment of the present invention; and
FIG. 11 is an exploded perspective view showing a display apparatus having an LED unit according to an exemplary embodiment of the present invention.

### DETAILED DESCRIPTION OF THE EXEMPLARY EMBODIMENTS

Hereinafter, exemplary embodiments of a display apparatus will be explained in detail with reference to the accompanying drawings. However, the scope of the present invention is not limited to such embodiments and the present invention may be realized in various forms. It should be understood that the figures may not be drawn to scale. Also, the same reference numerals may be used to designate the same elements throughout the drawings.

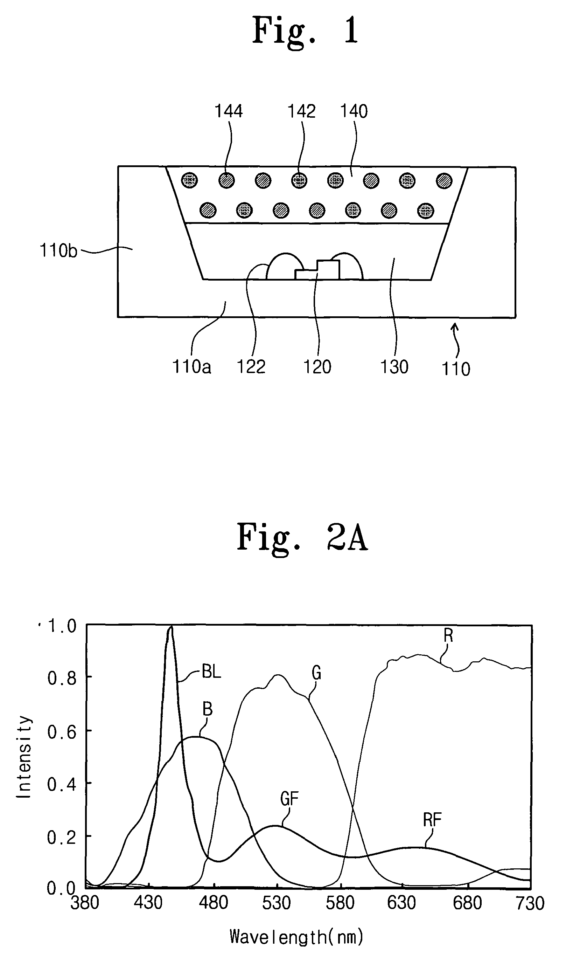

FIG. 1 is a sectional view illustrating an LED unit according to an exemplary embodiment of the present invention.

Referring to FIG. 1, the LED unit according to an exemplary embodiment of the present embodiment includes at least one LED 120 that emits light, a buffer layer 130 on the LED 120, and a quantum dot layer 140 on the buffer layer 130.

The LED 120, the buffer layer 130 and the quantum dot layer 140 are accommodated in a housing 110. The housing 110 has an internal space to receive the LED 120 thereon, the buffer layer 130 and the quantum dot layer 140. In detail, the housing 110 has a bottom portion 110a, on which the LED 120 can be mounted, and a side portion 110b extending upward from the bottom portion 110a. The housing 110 may be formed of an insulating polymer. For example, the housing 110 may include a plastic such as polyphthalamide (PPA) or a ceramic. The bottom portion 110a can be integrally formed with the side portion 11 0b through a molding process during the manufacturing of the housing 110.

The LED 120 is mounted on the bottom portion 110a of the housing 110 to emit light.

The LED 120 is connected to a power source (not shown) through wires 122. The wires 122 can be connected to the external power source by passing though the housing 110. The power source applies voltage to the LED 120 to drive the LED 120. Although not shown in FIG. 1, a heat sink pad or a heat sink plate can be provided to a lower portion of the LED 120 to dissipate heat generated from the LED 120.

The quantum dot layer 140 is formed over the LED 120 with the buffer layer 130 therebetween. The quantum dot layer 140 includes polymer resin in which a plurality of quantum dots 142 and 144 are dispersed and suspended. The polymer resin may include an insulating polymer resin such as silicon resin, epoxy resin and acryl resin.

Each quantum dot 142 or 144 is a nanomaterial and includes a core, which includes material having a small bandgap, a shell having a large bandgap while surrounding the core, and a ligand attached to the shell. The quantum dot 142 or 144 has a substantially spherical shape having a diameter of about 10nm. In the quantum dot has a nano-size and accordingly, a quantum confinement effect may occur. If the quantum confinement effect occurs, a bandgap of the quantum dot may increase. Further, unlike a crystalline structure, the quantum dot has a discontinuous bandgap structure that is similar to an individual atom. The bandgap of the quantum dot can be adjusted according to the size of the quantum dot. Thus, if the quantum dots are synthesized to have a uniform size distribution, a photo-conversion member having a spectral distribution with a narrow full width at half maximum (FWHM) can be obtained. According to exemplary embodiments of the present invention, the quantum dots 142 and 144 absorb the light emitted from the LED 120, and then emit light corresponding to bandgaps of the quantum dots 142 and 144. If the light emitted from the LED 120 is referred to as a first light and the light emitted from the quantum dots 142 and 144 is referred to as a second light, the first light has a wavelength equal to or shorter than that of the second light. Because energy emitted from the quantum dots may not be greater than the absorbed energy, the wavelength of the second light is equal to or longer than that of the first light.

The quantum dots 142 and 144 may use II -IV group quantum dots, such as ZnS, ZnSe, ZnTe, CdS, CdSe, CdTe, HgS, HgSe and HgTe, and III-V group quantum dots such as PbS, PbSe, PbTe, AlN, AlP, AlAs, AlSb, GaN, GaAs, GaSb, InN, InP, InAs and InSb.

When the LED 120 is a blue LED, the quantum dot layer 140 on the LED 120 may include a green quantum dot 142 and/or a red quantum dot 144. When the quantum dot layer 140 includes both the green quantum dot 142 and the red quantum dot 144, the final exit light, which is emitted out of the LED unit, becomes white light.

The LED unit as described above emits white light having high quality as compared with a conventional LED unit. This is because the LED unit of exemplary embodiments of the present invention can obtain superior spectral color reproduction as compared with the conventional LED unit using a fluorescent substance.

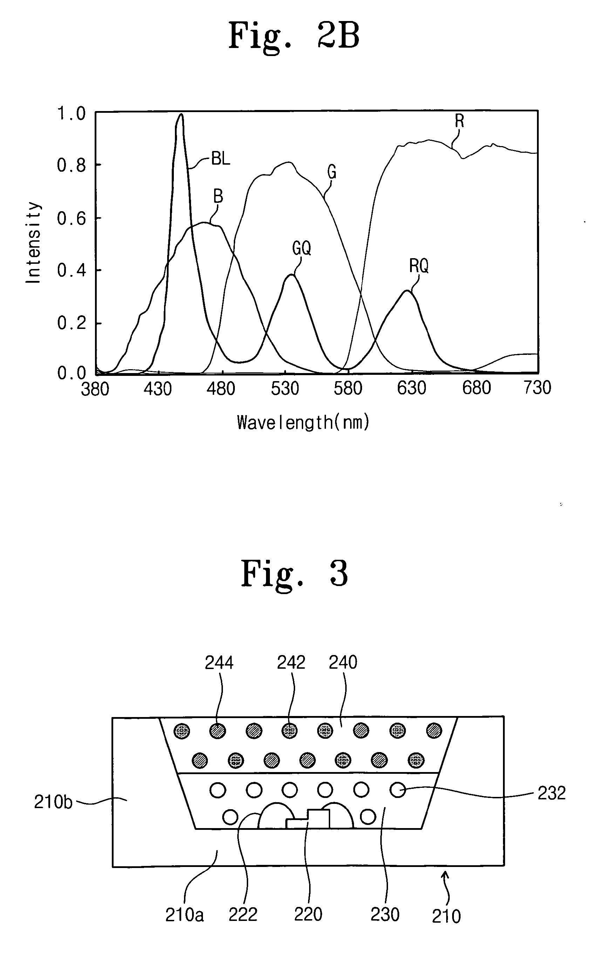

FIGS. 2A and 2B are spectral distribution graphs of the conventional LED unit using fluorescent substance and the LED unit according to exemplary embodiments of the present invention, respectively. In detail, the two graphs show spectral distribution of exit light according to the conventional LED unit and spectral distribution of exit light according to the embodiment of the present invention when using a blue LED, respectively. The graphs show relative light intensity as a function of a wavelength. In FIGS. 2A and 2B, R, G and B represent spectral distribution characteristics when red, green and blue color filters are used.

Referring to FIG. 2A, in the conventional LED unit using fluorescent substance, a blue peak BL, a green peak GF and a red peak RF are sequentially shown according to the wavelength. The blue peak BL, the green peak GF and the red peak RF have narrow FWHMs as compared with a case in which color filters are used. Particularly, the blue peak BL has a relatively very narrow FWHM as compared with the case in which the color filters are used. Further, the blue peak BL has a FWHM narrower than that of the green peak GF and the red peak RF. Thus, since the blue peak BL has high intensity in a narrow range, the blue peak BL has superior color reproduction as compared with that of the green peak GF and the red peak RF. This is because the conventional LED unit basically has a blue LED, and the blue peak BL has a FWHM of an LED light source. Meanwhile, in the conventional LED unit, the green peak GF and the red peak RF have relatively narrow FWHMs as compared with a case in which color filters are used. Nevertheless, the green peak GF and the red peak RF have the FWHMs wider that that of the blue peak BL and have intensity lower than that of the blue peak BL. This is because the green peak GF and the red peak RF are originated from light that is emitted from fluorescent substance which absorbs light emitted from the blue LED to emit light having a wavelength different from that of light emitted from the blue LED. Thus, the green peak GF and the red peak RF have the FWHM relatively wider than that of the blue peak BL, and overlap adjacent peaks representing other colors. That is, in the case of using fluorescent substance having a wide FWHM, as shown in FIG. 2A, the green peak GF overlaps the red peak RF, so density of yellow light may increase at a region around 580nm. Thus, pure red and green colors may not be obtained. As a result, the quality of white light may deteriorate due to mixture of adjacent lights.

Referring to FIG. 2B in which the spectral distribution of the quantum dot LED unit according to an exemplary embodiment of the present invention is shown, a blue peak BL, a green peak GQ and a red peak RQ are sequentially shown according to the wavelength. The blue peak BL, the green peak GQ and the red peak RQ have narrow FWHMs as compared with a case in which RGB color filters are used, and have relatively higher intensity. Thus, red, green and blue colors having high density are exhibited in a narrow range, so white color having high quality can be obtained. Here, the blue peak BL is based on a blue LED, while the green peak GQ and the red peak RQ are based on green and red quantum dots, respectively. Since the wavelength of the light emitted from the green and red quantum dots is defined within a specific range, very narrow FWHM is represented. In the case of employing the quantum dots having the narrow FWHM as described above, since yellow light rarely exists in the region around 580nm, pure red and green colors can be obtained through color filters.

In this regard, the LED unit using the quantum dot is used as a light source of a display apparatus, so that superior color reproduction can be obtained as compared with the conventional LED unit using the fluorescent substance.

Table 1 below shows the emission FWHM of the conventional fluorescent substance and the emission FWHM of the green and red quantum dots according to an exemplary embodiment of the present invention.

**Table 1**

| | LED unit using fluorescent substance | LED unit using quantum dots |
|---|---|---|
| Green FWHM (nm) | ∼ 60 | ∼ 35 |
| Red FWHM (nm) | ∼ 90 | ∼ 35 |

As described above, as compared with the convention LED unit, the LED unit of an exemplary embodiment of the present invention has superior color reproduction because the LED unit has an FWHM corresponding to half or less of the FWHM of the conventional LED unit. Thus, according to an exemplary embodiment of the present invention, the blue LED 120, the green quantum dot 142 and the red quantum dot 144 are used, so that the white light having high quality can be provided. The number of the green quantum dots 142 and the red quantum dots 144 can be varied according to a white color coordinate.

According to an exemplary embodiment of the present embodiment, the buffer layer 130 is formed between the blue LED 120 and the quantum dot layer 140. The buffer layer 130 separates the quantum dot layer 140 from the LED 120 to prevent the light emitted from the LED 120 from directly reaching the quantum dot layer 140 formed vertically above the LED 120. By forming the buffer layer 130 between the LED 120 and the quantum dot layer 140, the quantity of light directly reaching the quantum dot layer 140 can be reduced and simultaneously the scattering effect of the light emitted from the blue LED 120 can be increased.

The buffer layer 130 attenuates degradation of the quantum dot. The degradation of the quantum dot represents deformation of the quantum dot due to reaction with light, heat or chemical substances. For example, when the quantum dot is directly exposed to the light, heat or chemical material, especially for a long time, photooxidation reaction occurs, so the quantum dot is deformed. When no buffer layer exists, light having higher intensity is incident into the quantum dot layer formed vertically above the LED as compared with the quantum dot layer formed laterally above the LED, so the quantum dots aligned in the quantum dot layer, which is formed vertically above the LED, may be more degraded than other quantum dots within the quantum dot layer. Such a degradation may shorten the lifespan of the quantum dot layer formed vertically above the LED, so the quality of white light of the LED is lowered and the lifespan of the LED unit is shortened. Therefore, if the degradation of the quantum dot is prevented, the quality of the white light can be increased and the lifespan of the LED unit can be extended.

The buffer layer 130 may include a polymer resin such as silicon resin, epoxy resin and/or acryl resin.

FIG. 3 is a sectional view illustrating an LED unit according to an exemplary embodiment of the present invention. With respect to FIG. 3, only features different from those of FIG. 1 will be described to avoid redundancy. Similar reference numerals may be used to designate similar elements. For example, the quantum dot layer 240 may be similar to the quantum dot layer 140 of FIG. 1, the quantum dots 242 and 244 may be similar to the quantum dots 142 and 144 of FIG. 1, the housing 210 including a side portion 210b and a bottom portion 210a may be similar to the housing 110 including a side portion 110b and a bottom portion 110a of FIG. 1, and the wires 222 may be similar to the wires 122 of FIG. 1.

Referring to FIG. 3, a buffer layer 230 includes scattering agent 232 which is dispersed in resin (hereinafter, referred to as the first resin) constituting the buffer layer 230 to diffuse light emitted from an LED 220.

The scattering agent 232 is prepared in the form of particles that are uniformly dispersed in the first resin of the buffer layer 230. Each particle of the scattering agent 232 has a predetermined surface area to scatter light in various directions. The scattering agent 232 may be made of particles having a large surface area such as glass, titanium oxide (TiO₂), aluminum oxide (Al₂O₃) and/or silica.

Further, the scattering agent 232 may be contained in the first resin at a concentration in which the weight of the scattering agent 232 is about 1 % of the weight of the first resin to about 15 % of the weight of the first resin. When the scattering agent 232 is contained in the first resin at a concentration in which the weight of the scattering agent 232 is less than 1% of the weight of the first resin, light diffusion effect in cooperation with light scattering may be insufficient. When the scattering agent 232 is included in the first resin at a concentration in which the weight of the scattering agent 232 is greater than 15% of the weight of the first resin, light scattering effect is increased. However, since light loss is increased due to the light scattering and reflection, resulting light efficiency is reduced.

The scattering agent 232 may have a particle size that is larger than the quantum dots 242 and 244. When the scattering agent 232 has a particle size smaller than the diameter of the quantum dots 242 and 244, the proportion of the light, which is emitted from the quantum dots 242 and 244 and passes through the buffer layer 230 without being scattered, may increase. Accordingly, when the scattering agent 232 has a particle size smaller than the diameter of the quantum dots 242 and 244, the light may rarely contact with the scattering agent 232, causing degradation of the light scattering. In this regard, a scattering agent 232 having a particle size larger than the diameter of the quantum dots 242 and 244 may be used.

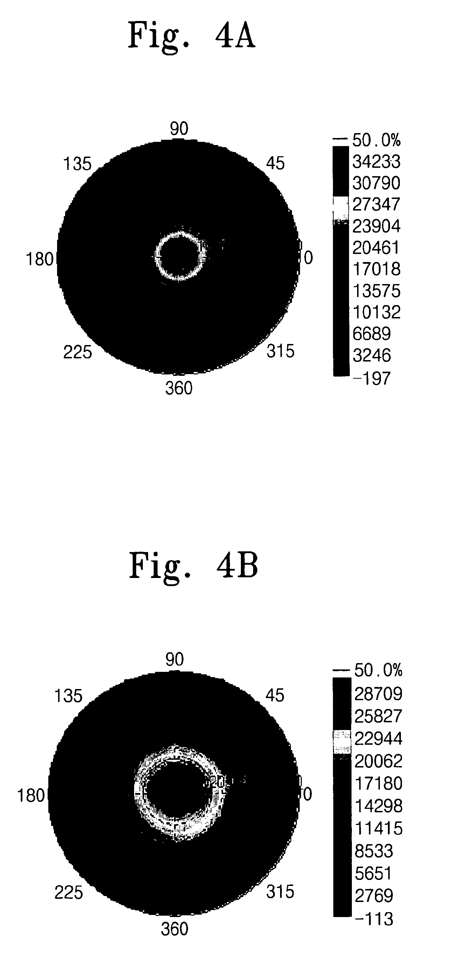

The particle of the scattering agent 232 may have an average diameter of about 50nm to about 10µm, in which the average diameter may be larger than the wavelength of blue light. The particle size of the scattering agent 232 may be selected according to a light-scattering surface area. When the particle of the scattering agent 232 has a diameter of more than 10µm, since the particle size of the scattering agent 232 is larger than the wavelength of the blue light, there may be significant diffraction as compared with scattering, so the scattering effect is lowered. Further, the proportion of the light, which is reflected in directions other than the upward direction, may increase due to the particle size of the scattering agent 232, so the light quantity may be unnecessarily reduced. Further, since the light scattering effect is increased proportionally to the surface area of the scattering agent 232, the particle of the scattering agent 232 may have a diameter of less than 10µm. When the particle of the scattering agent 232 has a diameter of less than 50nm, the particle size of the scattering agent 232 is small as compared with the wavelength of the blue light, so the scattering effect is significantly lowered. FIGS. 4A and 4B are views showing spatial light distribution of the LED unit when no scattering agent is used and when the scattering agent is used, respectively. In this case, titanium oxide (TiO₂) having an average diameter of about 200nm is used as the scattering agent at a concentration of about 5 % of the weight of the first resin layer.

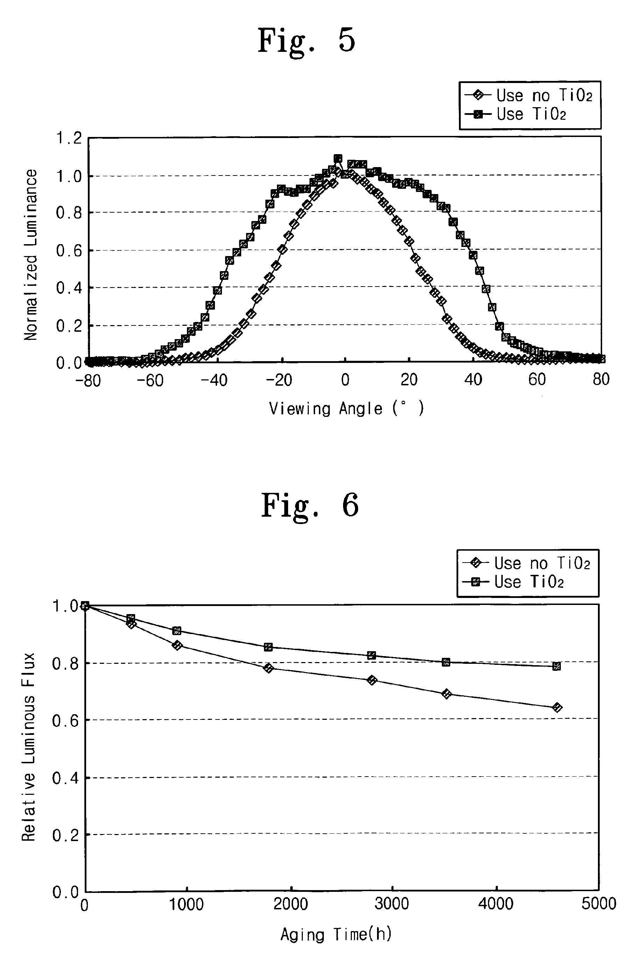

FIG. 5 is a graph showing the spatial light distribution shown in FIGS. 4A and 4B. In FIG. 5, an X axis denotes a viewing angle of the LED unit and a Y axis denotes normalized luminance according to an exemplary embodiment of the present invention.

As shown in FIG. 5, when the titanium oxide (TiO₂) is used, an angle, at which luminance corresponding to a half of maximum luminance is obtained, is about ±40°. However, when no titanium oxide (TiO₂) is used, the angle is about ±23°. This result represents that the light emitted from the LED is spatially diffused by the scattering agent through scattering and dispersion.

The light diffusion represents that quantity of light directly reaching the quantum dots formed vertically above the LED is relatively reduced, which signifies that light is dispersed to the quantum dot layer formed laterally above the LED. As a result, the quantity of light directly reaching the quantum dots formed vertically above the LED is reduced, so the degradation of the quantum dots is lowered. Thus, the quality of the white light can be increased and the lifespan of the quantum dot diode can be extended.

FIG. 6 is a graph showing light quantity characteristics as a function of aging time when no scattering agent is used and when the scattering agent is used. In FIG. 6, an X axis denotes the aging time of the LED unit and a Y axis denotes relative luminous flux as a function of the aging time according to an exemplary embodiment of the present invention. Titanium oxide (TiO₂) having an average diameter of about 200nm is used as the scattering agent at a concentration of about 5 % of the weight of the first resin layer.

As shown in FIG. 6, when the titanium oxide (TiO₂) is used, the luminous flux of the LED unit according to the aging time at a predetermined time period is less reduced as compared with the case in which no titanium oxide (TiO₂) is used. In detail, when the titanium oxide (TiO₂) is used, the gradient of the relative luminous flux is smooth as compared with the case in which no titanium oxide (TiO₂) is used.

The lifespan of the LED unit may be defined as the aging time at which the luminous flux of the LED unit is about equal to half of the initial luminous flux. In the graph of FIG. 6, since the luminous flux is smoothly reduced when the titanium oxide (TiO₂) is used, the lifespan of the LED unit is extended. Accordingly, when the titanium oxide (TiO₂) is used for the buffer layer, the degradation of the quantum dot is attenuated and thus the lifespan of the LED unit is extended.

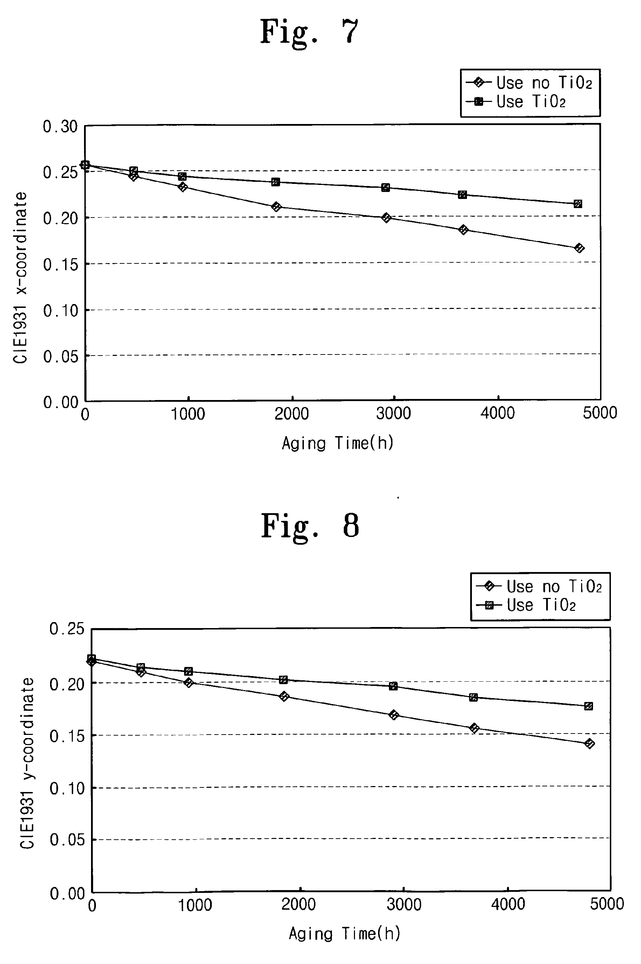

FIGS. 7 and 8 are graphs showing X and Y coordinate colorimetric characteristics as a function of aging time when no scattering agent is used and when the scattering agent is used, respectively. In FIGS. 7 and 8, the X axis denotes the aging time of the LED unit and the Y axis denotes the color coordinate as a function of the aging time according to an exemplary embodiment of the present invention. FIG. 7 shows an X-coordinate of a CIE1931 standard colorimetric system and FIG. 8 shows a Y coordinate of the CIE1931 standard colorimetric system. Titanium oxide (TiO₂) having an average diameter of about 200nm is used as the scattering agent at a concentration of about 5 % of the weight of the first resin layer.

As shown in FIGS. 7 and 8, as a result of measuring the color coordinate of the LED unit according to the aging time at a predetermined time period, variation of the color coordinate is relatively small when the titanium oxide (TiO₂) is used as a scattering agent, as compared with the case in which no titanium oxide (TiO₂) is used. That is, variation of the color coordinate is relatively small when the titanium oxide (TiO₂) is used, as compared with the case in which no titanium oxide (TiO₂) is used. In general, since variation of the color coordinate represents the change of a color, the color may not be stably expressed as variation of the color coordinate is large. In this regard, when the titanium oxide (TiO₂) is used as the scattering agent, a color can be stably provided and thus the white light having high quality can be continuously provided, as compared with the case in which no titanium oxide (TiO₂) is used. As a result, according to an exemplary embodiment of the present invention, when the titanium oxide (TiO₂) is used, the degradation of the quantum dot is attenuated, so that the white light is stably supplied.

The present invention is not limited to the exemplary embodiments set forth herein. For example, the scattering agent may be uniformly dispersed in the buffer layer or the buffer layer may include plural buffer sub-layers and a scattering agent having different densities may be dispersed in each buffer layer.

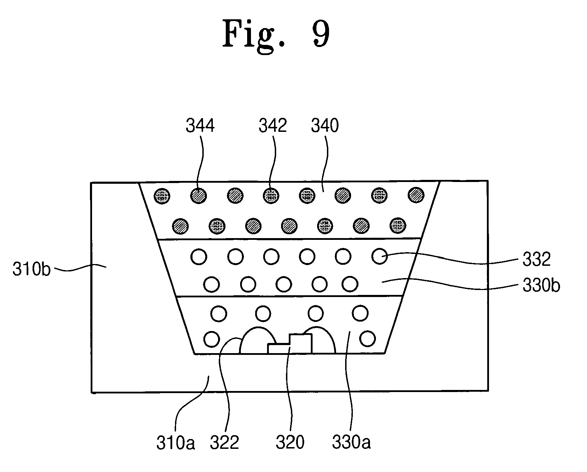

FIG. 9 is a sectional view illustrating an LED unit according to an exemplary embodiment of the present invention. With respect to FIG. 9, only features different from those of FIGs. 1 and 3 will be described to avoid redundancy. Similar reference numerals may be used to designate similar elements. For example, the quantum dot layer 340 may be similar to the quantum dot layer 140 of FIG. 1, the quantum dots 342 and 344 may be similar to the quantum dots 142 and 144 of FIG. 1, the housing including a side portion 310b and a bottom portion 310a may be similar to the housing 110 including a side portion 110b and a bottom portion 110a of FIG. 1, and the wires 322 may be similar to the wires 122 of FIG. 1.

Referring to FIG. 9, a buffer layer includes a first buffer sub-layer 330a and a second buffer sub-layer 330b. The first buffer sub-layer 330a is formed on an LED 320 and the second buffer sub-layer 330b is formed on the first buffer sub-layer 330a.

The first and second buffer sub-layers 330a and 330b may include insulating material such as a polymer resin. A scattering agent 332 may be dispersed in the first and second buffer sub-layers 330a and 330b and the scattering agent may have a different concentration within each buffer sub-layer. For example, the scattering agent 332 dispersed in the first buffer sub-layer 330a has a concentration lower than that of the scattering agent 332 dispersed in the second buffer sub-layer 330b.

Light emitted from the LED 320 is primarily scattered and diffused in the first buffer sub-layer 330a, and then secondarily scattered and diffused in the second buffer sub-layer 330b. Since the scattering agent 332 dispersed in the second buffer sub-layer 330b has higher concentration than in the first buffer sub-layer 330a, the scattering effect increases as light travels from the first buffer sub-layer 330a to the second buffer sub-layer 330b, so the quantity of light incident into a quantum dot layer is uniformly dispersed.

As described above, the scattering agent 332 occurs with different concentrations in the first and second buffer sub-layers 330a and 330b and the light diffusion can thereby be easily adjusted according to the density or type of quantum dots provided.

According to an exemplary embodiment of the present embodiment, the first and second buffer sub-layers 330a and 330b are formed in parallel with a bottom portion 310a of a housing. However, the present invention is not limited thereto. For example, plural buffer sub-layers may be formed perpendicularly to the bottom portion 310a. For example, although not shown in the drawing, an area formed vertically above the LED 320, and an area formed laterally above the LED 320 may be formed, so three buffer sub-layers may be formed. Further, the scattering agent 332 having the highest concentration is dispersed in the buffer sub-layer of the area formed vertically above the LED 320, so that the light diffusion effect can be maximized.

The above-described exemplary embodiments relate to the LED unit having a single LED. However, other exemplary embodiments of the present invention may include an LED unit having a plurality of LEDs.

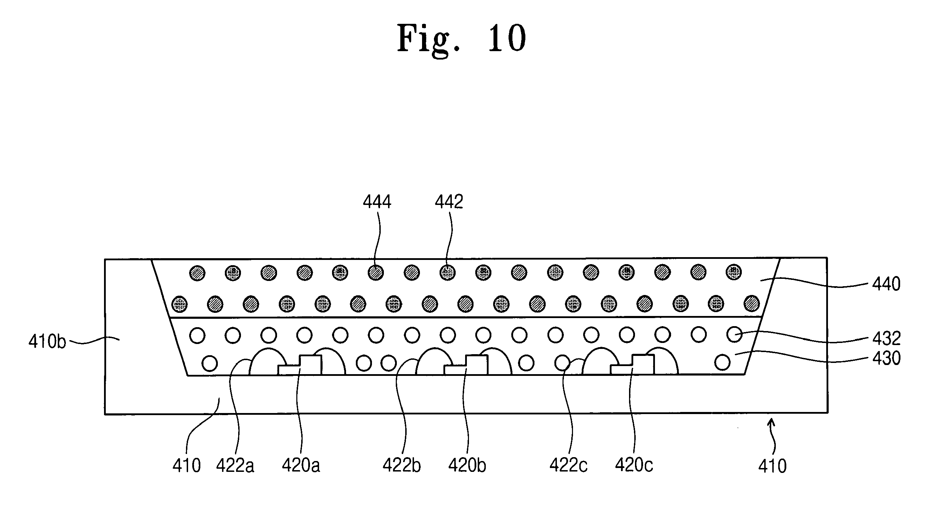

FIG. 10 is a sectional view illustrating an LED unit according to an exemplary embodiment of the present invention. Here, a plurality of LEDs 420a, 420b and 420c are mounted on a housing 410. With respect to FIG. 10, only features different from those of FIGs. 1, 3 and 9 will be described to avoid redundancy. Similar reference numerals may be used to designate similar elements. For example, the quantum dot layer 440 may be similar to the quantum dot layer 140 of FIG. 1, the quantum dots 442 and 444 may be similar to the quantum dots 142 and 144 of FIG. 1, the housing 410 including a side portion 410b and a bottom portion 410a may be similar to the housing 110 including a side portion 110b and a bottom portion 110a of FIG. 1, the buffer layer 430 may be similar to the buffer layer 230 of FIG. 3, and the scattering agent 432 may be similar to the scattering agent 232 of FIG. 3.

Referring to FIG. 10, a bottom portion 410a of the housing 410 is widely formed, and the LEDs 420a, 420b and 420c are provided on the bottom portion 410a of the housing 410. The LEDs 420a, 420b and 420c may be connected with one power source or separate power sources through wires 422a, 422b and 422c. The LEDs 420a, 420b and 420c may be arranged at a predetermined interval and may also be randomly provided, where it is desired.

A buffer layer 430 is provided on the LEDs 420a, 420b and 420c while being integrally formed with the LEDs 420a, 420b and 420c. A quantum dot layer 440 including quantum dots 442 and 444 is provided on the buffer layer 430.

An area of the light source of the LED unit may be wide and/or long, as compared with the LED unit using only a single LED 420.

According to the LED unit having the above structure, the quantity of light directly incident into the quantum dot layer formed vertically above the LEDs is diffused such that the light can be dispersed and incident into the quantum dot layer, and the degradation of the quantum dots in some areas of the quantum dot layer can be lowered and the lifespan of the LED unit can be extended. Further, the degradation of the quantum dots is lowered, so that the color reproduction of the LED unit can be increased.

Consequently, the LED unit according to an exemplary embodiment of the present invention provides a light source having high quality. The LED unit according to an exemplary embodiment of the present invention may be used as a point light source. Further, a plurality of the LED units may be arranged such that the LED units are used as a surface light source. The LED unit may be used for various purposes. Particularly, the LED unit can be used as a light source of a display apparatus of a non-emissive type such as a liquid crystal display (LCD) or an electrophoretic display (EPD).

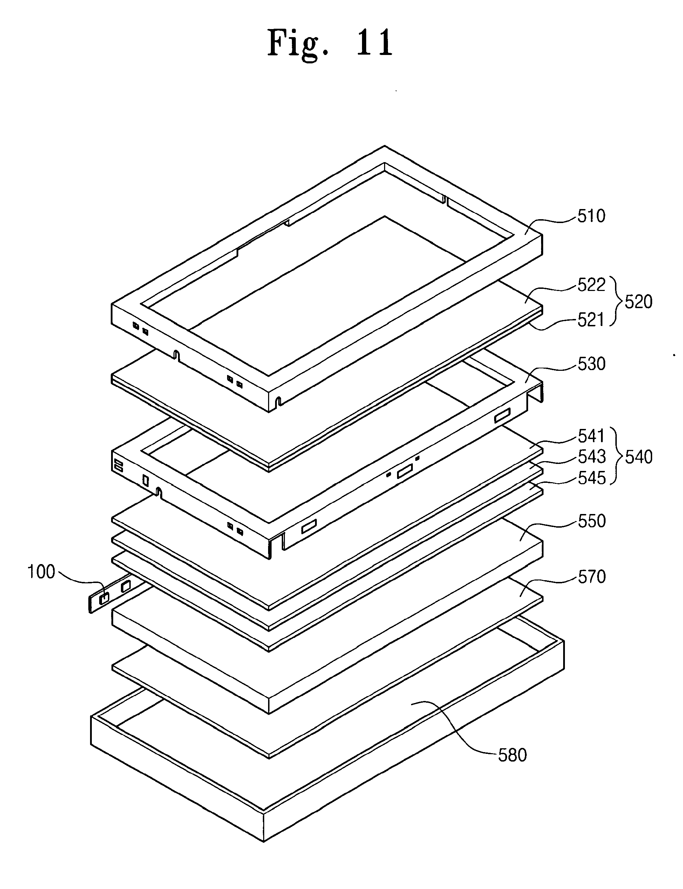

FIG. 11 is an exploded perspective view showing a display apparatus using the LED unit according to an exemplary embodiment of the present invention as a light source. In FIG. 11, an LCD is used as a display panel as an example.

Referring to FIG. 11, the LCD according to an exemplary embodiment of the present invention includes the display panel 520 that displays images in a front direction thereof. A mold frame 530 is provided at edges of the display panel 520 to support the display panel 520. An optical sheet unit 540 is provided under the mold frame 530 and below the display panel 520. The optical sheet unit 540 may include a protection sheet 541, a prism sheet 543 and/or a diffusion sheet 545, which are provided in a rear direction of the display panel 520.

The LED unit 100 according to an exemplary embodiment of the present invention is provided near the optical sheet unit.540, for example, at the bottom surface or side surface of the optical sheet unit 540, thereby supplying light to the display panel 520 through the optical sheet unit 540. In an exemplary embodiment of the present invention, the LED unit 100 is provided at the side surface of the optical sheet unit 540, thereby forming an edge type display apparatus. However, the present invention is not limited thereto. The present invention may include a direct type display apparatus (not shown), in which the LED unit 100 is provided at the back of the display panel 520, as well as the edge type display apparatus in which the LED unit 100 is provided at one side of the display panel 520.

A light guide plate 550 is provided between the LED unit 100 and the optical sheet unit 540 to guide the light emitted from the LED unit 100 toward the optical sheet unit 540 and the display panel 520.

A reflective sheet 570 is provided under the light guide plate 550 to reflect light directed downward through the light guide plate 550 such that the light travels toward the display panel 520. The reflective sheet 570 is provided at a bottom surface thereof with a bottom cover 580 that receives the display panel 520, the optical sheet unit 540, the light guide plate 550, the LED unit 100 and the reflective sheet 570 therein while being coupled with the display panel 520, the optical sheet unit 540, the light guide plate 550, the LED unit 100 and the reflective sheet 570. Further, a top cover 510 is provided on the display panel 520 to be coupled with the bottom cover 580. The top cover 510 serves as a structure that supports the front edges of the display panel 520. The top cover 510 is provided with a display window to expose a display area of the display panel 520. The top cover 510 is provided at a side surface thereof with coupling members such as screw holes (not shown) coupled with the bottom cover 580.

The display panel 520 is prepared in the form of a rectangular plate having long and short sides. The display panel 520 includes a first substrate 521, a second substrate 522 facing the first substrate 521, and liquid crystal layer (not shown) interposed between the two substrates 521 and 522. The display panel 520 drives the liquid crystal layer to display images in the front direction thereof. In an exemplary embodiment, a liquid crystal panel is used as the display panel. However, the present invention is not limited thereto. Other display panels requiring a light source may be used. For example, an electrophoresis display panel may be used.

Although not shown in the drawing, the display panel 520 may be provided at one side thereof with a printed circuit board connected with thin film transistors of the display panel 520. Signals output from the printed circuit board are transferred to the thin film transistors through interconnections, so the thin film transistors apply voltage to pixels in response to the signals to drive the liquid crystal layer.

As described above, the LED unit according to an exemplary embodiment of the present invention supplies white light having high quality and long endurance. Thus, when the LED unit is used as the light source of the display apparatus as described above, the quality of the display apparatus can be increased.

The present invention includes a method of manufacturing the LED unit having the above structure. Hereinafter, the manufacturing method of the LED unit according to an exemplary embodiment of the present invention will be described with reference to FIG. 3.

First, the housing 210 for receiving the LED 220 is prepared.

The housing 210 includes a bottom portion 210a, and a side portion 210b extending from the bottom portion 210a while being bent upward from the bottom portion 210a. The housing 210 may be manufactured using insulating polymer resin, such as polyphthalamide (PPA), for example, through a molding process.

Further, a heat sink plate or a heat sink pad may be provided by passing through the bottom portion 210a of the housing 210 to dissipate heat emitted from the LED 220 to be mounted later.

Next, the LED 220 is mounted on the bottom portion 210a of the housing 210. The LED 220 is connected to a power source (not shown) through wires 222. The power source may be provided by having the wires 222 pass through the housing 210 while being connected to an external power source. When the LED unit is mounted on another element such as a printed circuit board, the wires 222 are connected to electrodes on the printed circuit board to apply external power to the LED 220.

Then, the buffer layer 230 is formed on the LED 220. To this end, the solid-phase scattering agent 232 is mixed with the first resin such as silicon resin, epoxy resin and acryl resin, to form a first mixture.

Thereafter, the first mixture is coated on the bottom portion 210a of the housing including the LED 220 thereon. Various methods may be adopted to coat the first mixture on the LED 220. For example, such methods can coat the liquid-phase mixture on the LED 220. For example, an inkjet method may be used. After the coating process, the first mixture is cured to form the buffer layer 230. For example, during the curing process, heat is applied to the first mixture to form the buffer layer 230. Where desired, photo-curing using ultraviolet ray may be used.

When the buffer layer 230 has a single layer structure, the buffer layer 230 is formed through a one-time coating process. However, when the buffer layer 230 includes a multi-layer structure, the buffer layer 230 is formed by repeating the coating and curing processes several times. For example, when forming first and second buffer sub-layers each having different concentration of the scattering agent, third mixture is prepared by mixing scattering agent having a predetermined concentration with the first resin. Next, the third mixture is coated on the bottom portion including the LED, and cured to form the first buffer sub-layer. Then, the fourth mixture is prepared by mixing scattering agent having a predetermined concentration with the first resin such that the fourth mixture has a concentration different from that of the third mixture. The four mixture is coated on the first buffer sub-layer and cured to form the second buffer sub-layer.

After forming the buffer layer 230, the quantum dot layer 240 having quantum dots therein is formed on the buffer layer 230. For example, the quantum dots are mixed with volatile solvent such as toluene. Since the solvent has very high volatility, the solvent can be easily removed during the subsequent mixing process. Next, a second mixture is formed by mixing the quantum dots with the second resin such as a silicon resin, epoxy resin and acryl resin.

Then, the second mixture is coated on the buffer layer 230. Various methods may be adopt to coat the second mixture on the buffer layer 230. For example, such methods may coat the liquid-phase mixture on the buffer layer 230. For example, an inkjet method may be used. After the coating process, the second mixture is cured to form the quantum dot layer 240. For example, during the curing process, heat is applied to the second mixture to form the quantum dot layer 240. At this time, photo-curing is not used because the quantum dots may be degraded by light.

Although exemplary embodiments of the present invention have been described, it is understood that the present invention should not be limited to these exemplary embodiments but various changes and modifications can be made by one ordinary skilled in the art.

## Claims

1. A light emitting diode unit comprising:
at least one light emitting diode emitting first light;
a quantum dot layer provided on the light emitting diode comprising a plurality of quantum dots absorbing a portion of the first light and emitting second light having a wavelength different from a wavelength of the first light; and
a buffer layer interposed between the light emitting diode and the quantum dot layer separating the quantum dot layer from the light emitting diode.

2. The light emitting diode unit of claim 1, wherein each quantum dot has a diameter of about 4nm to about 10nm and comprises:
a core;
a shell surrounding the core and comprising material having a bandgap larger than a bandgap of the quantum dot; and
a ligand attached to the shell.

3. The light emitting diode unit of claim 1, wherein the buffer layer comprises:
resin; and
scattering agent dispersed in the resin to diffuse the first light emitted from the light emitting diode.

4. The light emitting diode unit of claim 3, wherein the scattering agent comprises a plurality of particles each of which having a diameter larger than the diameter of the quantum dot.

5. The light emitting diode unit of claim 3, wherein the scattering agent comprises a plurality of particles having a diameter of about 50nm to about 10µm.

6. The light emitting diode unit of claim 5, wherein the diameter of each particle of the scattering agent is larger than a wavelength of blue light.

7. The light emitting diode unit of claim 2, wherein the scattering agent is contained in the resin at a concentration of about 1 % by weight to about 15 % by weight for the resin.

8. The light emitting diode unit of claim 1, wherein the buffer layer comprises a plurality of buffer sub-layers, and each buffer sub-layer has a different concentration of the scattering agent.

9. The light emitting diode unit of claim 8, wherein the buffer layer has a dual layer structure in which a first buffer sub-layer is formed on the light emitting diode, and a second buffer sub-layer is formed on the first buffer sub-layer, and a concentration of the scattering agent in the first buffer sub-layer is lower than a concentration of the scattering agent in the second buffer sub-layer.

10. The light emitting diode unit of claim 1, wherein the buffer layer comprises a silicon resin, an epoxy resin or an acryl resin.

11. The light emitting diode unit of claim 1, wherein the scattering agent comprises bead glass, titanium oxide, aluminum oxide or silica glass.

12. A display apparatus comprising:
a display panel display images; and
a light emitting diode unit supplying light to the display panel,
wherein the light emitting diode unit comprises:
at least one light emitting diode emitting first light;
a buffer layer provided on the light emitting diode, the buffer layer comprising a scattering agent that diffuses the first light; and
a plurality of quantum dots provided on the buffer layer absorbing a portion of the first light and emitting light of a second light having a wavelength different from a wavelength of the first light.

13. The display apparatus of claim 12, wherein each quantum dot has a diameter of about 4nm to about 10nm and comprises:
a core;
a shell surrounding the core and comprising material having a bandgap larger than a bandgap of the quantum dot; and
a ligand attached to the shell.

14. The display apparatus of claim 12, wherein the scattering agent comprise a plurality of particles each of which having a diameter larger than the diameter of the quantum dot.

15. The display apparatus of claim 12, wherein the diameter of each particle is larger than a wavelength of blue light.
